# EUROPEAN PATENT APPLICATION

(11) **EP 4 671 155 A1**
(43) Date of publication of application: **31.12.2025**
(21) Application number: 23924166.4
(22) Date of filing: 31.10.2023
(51) Int. Cl.: B65G 1/00, B65G 1/04, B66C 17/00, B66C 13/08, H01L 21/677

(54) **TRANSPORT APPARATUS**

(30) Priority: 24.02.2023 JP 2023027429
(71) Applicant: Murata Machinery, Ltd., Kyoto-shi, Kyoto 601-8326 (JP)
(72) Inventor: ITO Yasuhisa, Kyoto-shi, Kyoto 612-8686 (JP)
(74) Representative: Hoffmann Eitle
(86) International application number: PCT/JP2023/039298
(87) International publication number: WO 2024/176522

(57) **Abstract**

Provided is a transport apparatus of an overhead traveling type that can transport an article by appropriately inclining the article, regardless of an elevating/lowering distance. In a transport apparatus of an overhead traveling type (overhead traveling vehicle) 1 of the present invention, an elevating/lowering device 8 includes first and second belt members 12, 14 configured to suspend a holding device 10, and driving devices 26, 30, 34 configured to wind up and wind down the belt members, the holding device 10 and a vehicle body 2 include abutting members/abutted members 44, 46 that abut against each other at a reference elevation position, the first belt members 12 suspend the holding device 10 at first positions A, the second belt member 14 suspends the holding device 10 at a second position B, and the transport apparatus includes springs 52 configured to, when the first and second belt members 12, 14 are wound up by the same length at the reference elevation position, allow the holding device 10 to be inclined by α1, α2 by using abutting portions 46a, 44a between the abutting members 46 and the abutted members 44 as fulcrums.

## Description

### Technical Field

The present invention relates to a transport apparatus, and particularly relates to a transport apparatus of an overhead traveling type that travels along an overhead track to transport an article.

### Background Art

Patent Literature 1 discloses an overhead traveling transport apparatus that transports a cassette in an inclined state. This overhead traveling transport apparatus is configured such that the cassette is gripped by grippers attached to the distal ends of two belts, and the respective belts are wound up by drums having different diameters, thus causing the two belts to have different winding-up amounts, and consequently, the grippers that are in a horizontal posture at the lower limit position are gradually inclined as the grippers are elevated, and the grippers take a target inclined posture at the upper limit position.

### Citation List

### Patent Literature

Patent Literature 1: Japanese Patent Laid-Open No. 8-188375

### Summary of Invention

### Technical Problem

However, in the overhead traveling transport apparatus of Patent Literature 1 described above, to cause the cassette to be inclined at a certain target inclination angle, it is necessary to adjust the lengths of the belts and the diameters of the drums according to elevating/lowering distances (that is, a distance between the lower limit position and the upper limit position of the cassette). Accordingly, to obtain the optimum inclination angle of the cassette, it is necessary to adjust the lengths of the belts and the diameters of the drums according to a height to an overhead track and to specifications of a load port and the like for each facility to which such a transport apparatus is provided and hence, there is the problem that complicated handling is required, thus increasing costs.

The present invention has been made to solve the problems described above, and it is an object of the present invention to provide a transport apparatus of an overhead traveling type that can transport articles by appropriately inclining the articles, regardless of an elevating/lowering distance.

### Solution to Problem

To achieve the above-mentioned object, the present invention is directed to a transport apparatus of an overhead traveling type, the transport apparatus traveling along an overhead track to transport an article, the transport apparatus including: a vehicle body; a holding device configured to hold the article; and an elevating/lowering device configured to elevate/lower the holding device relative to the vehicle body, wherein the elevating/lowering device includes a first suspension member, a second suspension member, and a driving device, the first suspension member and the second suspension member being configured to suspend the holding device, the driving device being configured to wind up and wind down the first suspension member and the second suspension member, the holding device includes an abutting member configured to abut against the vehicle body at a predetermined elevation position up to which the holding device is elevated relative to the vehicle body, the vehicle body includes an abutted member against which the abutting member of the holding device abuts, the first suspension member is configured to suspend the holding device at a first position on the holding device, and the second suspension member is configured to suspend the holding device at a second position on the holding device, the driving device is configured to wind up or wind down the first suspension member and the second suspension member by a same length, and the transport apparatus further includes an allowance part configured to, when the first suspension member and the second suspension member are wound up by the same length at the predetermined elevation position at which the abutting member of the holding device abuts against the abutted member of the vehicle body, allow the holding device to be inclined by using an abutting portion between the abutting member and the abutted member as a fulcrum.

According to the present invention having such a configuration, the elevating/lowering device and the allowance part are provided, the elevating/lowering device being configured to wind up the first suspension member and the second suspension member by the same length, the allowance part being configured to, when the first suspension member and the second suspension member are wound up by the same length at the predetermined elevation position at which the abutting member of the holding device abuts against the abutted member of the vehicle body, allow the holding device to be inclined by using the abutting portion between the abutting member and the abutted member as the fulcrum. Accordingly, the holding device can be inclined by a certain desired inclination angle, irrespective of an elevating/lowering distance (the winding-up amount of the suspension member).

In the present invention, it is preferable that the abutting member of the holding device be provided between the first position and the second position as viewed in a horizontal direction, and when the first suspension member and the second suspension member are wound up by the same length at the predetermined elevation position, the allowance part allow the holding device to be inclined such that the first position is displaced upward, and the second position is displaced downward by using the abutting portion between the abutting member and the abutted member as the fulcrum.

According to the present invention having such a configuration, the holding device can be inclined more effectively by a certain desired inclination angle.

In the present invention, it is preferable that the allowance part include an elastic member configured to, when the first suspension member and the second suspension member are wound up by the same length at the predetermined elevation position, be elastically deformed to allow the holding device to be inclined by using the abutting portion between the abutting member and the abutted member as the fulcrum.

According to the present invention having such a configuration, it is possible to more effectively allow the holding device to be inclined.

In the present invention, it is preferable that the elastic member be contracted with respect to a natural length of the elastic member in a state in which the holding device holds no article.

According to the present invention having such a configuration, the elastic member is contracted with respect to the natural length thereof and hence, a pressurization that is generated by a corresponding amount is applied to the holding device. Accordingly, when the holding device holding the article is lifted (from the load port, for example), it is possible to suppress the inclination of the holding device.

In the present invention, it is preferable that the abutting member of the holding device and the abutted member of the vehicle body define a horizontal position and an elevation position of the holding device at the predetermined elevation position.

According to the present invention having such a configuration, in addition to the role as the fulcrum when the holding device is inclined, the abutting member of the holding device and the abutted member of the vehicle body also play a role in positioning when the holding device is elevated.

In the present invention, it is preferable that a first connecting member be provided at the first position of the holding device, the first connecting member connecting the first suspension member to a base member of the holding device, a second connecting member be provided at the second position of the holding device, the second connecting member connecting the second suspension member to the base member of the holding device, the first connecting member be fixed to the base member, the second connecting member be attached to the base member to be displaceable in an up-down direction relative to the base member, and the allowance part include an elastic member that is provided between the base member and the second connecting member to allow a relative displacement between the base member and the second connecting member.

According to the present invention having such a configuration, the elastic member is deflected by receiving a force from the base member of the holding device and the second connecting member connected to the second suspension member and hence, it is possible to effectively allow the holding device to be inclined.

In the present invention, it is preferable that the abutting member be a pin member that protrudes upward, and the abutted member be a guide member that is open downward, and that is configured to receive and support the pin member.

According to the present invention having such a configuration, the holding device can be more effectively inclined by a certain desired inclination angle.

### Advantageous Effect of Invention

According to the present invention, it is possible to transport the articles by appropriately inclining the articles, regardless of an elevating/lowering distance.

### Brief Description of Drawings

[Figure 1] Figure 1 is a side view showing a schematic configuration of an entire transport apparatus of an overhead traveling type according to an embodiment of the present invention.
[Figure 2] Figure 2 is a left side view of an elevating/lowering device of the transport apparatus according to the embodiment of the present invention as viewed from the left side, showing a schematic configuration of the device.
[Figure 3] Figure 3 is a top plan view of the elevating/lowering device of the transport apparatus according to the embodiment of the present invention as viewed from the top, showing the schematic configuration of the device.
[Figure 4] Figure 4 is a front view of a holding device according to the embodiment of the present invention, showing a schematic configuration of the device.
[Figure 5] Figure 5 is a left side view of the holding device according to the embodiment of the present invention, showing the schematic configuration of the device.
[Figure 6] Figure 6 is a back view of the holding device according to the embodiment of the present invention, showing the schematic configuration of the device.

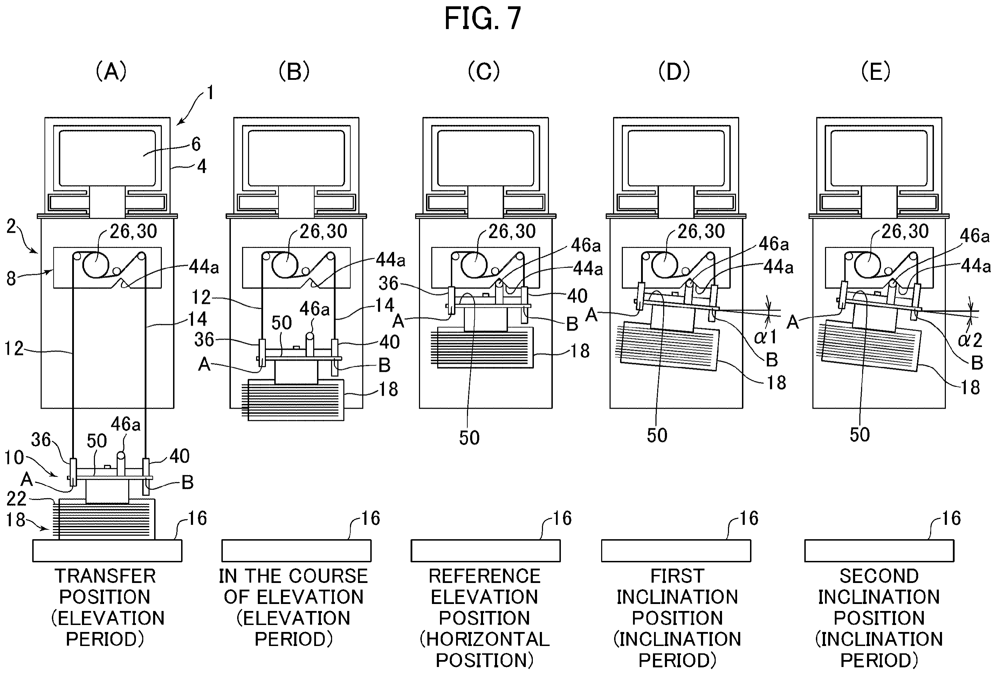

[Figure 7] Figure 7 is schematic view showing operation patterns of the transport apparatus of the present embodiment, wherein Figure 7(A) is a diagram for illustrating an operation at a transfer position at which the holding device has access to transport articles on a load port, Figure 7(B) is a diagram for illustrating an operation in the course of elevation in which the holding device is lifted by elevating/lowering belts, Figure 7(C) is a diagram for illustrating an operation when the holding device is lifted to a reference elevation position, Figure 7(D) is a diagram for illustrating an operation of the holding device in the course of further winding up the elevating/lowering belts, and Figure 7(E) is a diagram for illustrating an operation of the holding device when winding-up of the elevating/lowering belts is completed.
[Figure 8] Figure 8 is a partially enlarged view of Figure 7(C) for illustrating the operation of the holding device at the reference elevation position in more detail.
[Figure 9] Figure 9 is a partially enlarged view of Figure 7(D) for illustrating an inclination operation of the holding device in more detail.
[Figure 10] Figure 10 is a partially enlarged view of Figure 7(E) for illustrating the inclination operation of the holding device in more detail.

### Description of Embodiment

Next, a transport apparatus of an overhead traveling type according to an embodiment of the present invention will be described with reference to the attached drawings.

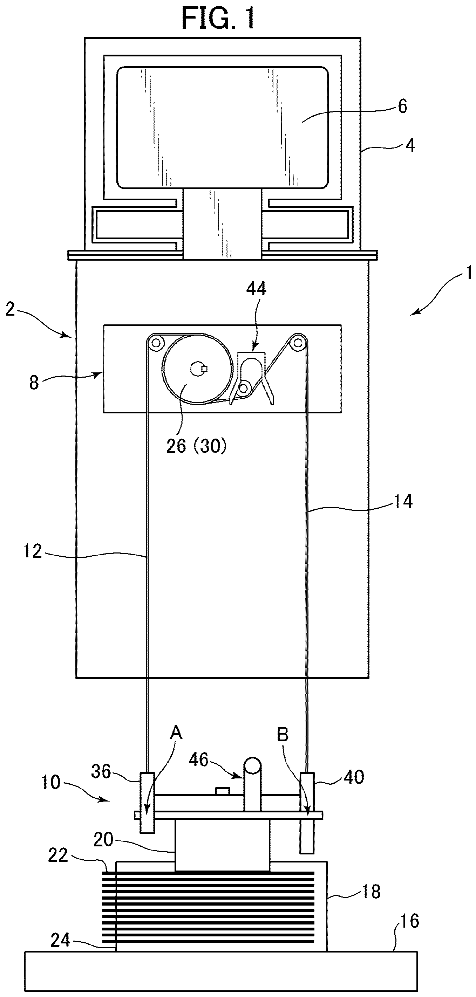

First, the overall configuration of the transport apparatus of the overhead traveling type (overhead carrier) according to the embodiment of the present invention will be described with reference to Figure 1. Figure 1 is a side view showing a schematic configuration of the entire transport apparatus of the overhead traveling type according to the embodiment of the present invention. In the present embodiment described hereinafter, the present invention is applied to a transport apparatus that houses and transports semiconductor wafers in a cleanroom in a semiconductor manufacturing factory.

First, as shown in Figure 1, reference symbol "1" denotes the transport apparatus of the overhead traveling type (overhead carrier) of the present embodiment (hereinafter referred to as "transport apparatus"). This transport apparatus 1 includes a transport vehicle body (hereinafter referred to as "vehicle body") 2. This vehicle body 2 is suspended on a track rail 4 attached to the ceiling in a building, such as a cleanroom, travels via a traveling mechanism 6, and thus can be moved to a target position, the traveling mechanism 6 being moved relative to the track rail 4.

In the description made hereinafter and respective drawings, "front side" and "rear side" refer to the front side and the rear side of the transport apparatus 1 as viewed in a direction orthogonal to the traveling direction of the transport apparatus 1 and in the horizontal direction, and "lateral side" refers to a lateral side relative to the front side and the rear side of the transport apparatus 1. Further, "front side" refers to the front side of the transport apparatus 1 as viewed from the direction of the side having an opening part 24 of an open cassette 18 described later.

Next, the transport apparatus 1 includes an elevating/lowering device (elevator) 8 and a holding device (a hand unit equipped with a tilting mechanism) 10.

The elevating/lowering device 8 is a device that serves as a so-called hoist to elevate/lower the holding device 10 with elevating/lowering belts 12, 14. The elevating/lowering device 8 is attached to the vehicle body 2 at a position below the traveling mechanism 6 described above.

The holding device 10 grips (holds) the open cassette 18, which is placed on a load port 16 of a semiconductor manufacturing apparatus installed in a building, with a chuck 20 to allow the transportation of wafers (transport articles) 22 in the open cassette 18.

The open cassette 18 has the opening part 24 formed on one side, which is the front side thereof, and the wafers 22 on the load port 16 are horizontally transferred into the open cassette 18 from this opening part 24 (the wafers 22 can be taken into/out from the open cassette 18 through this opening part 24). To facilitate understanding, the wafers 22 are illustrated in a state of protruding from the opening part 24 of the open cassette 18 in drawings in side view including Figure 1. However, in practice, the entire wafers 22 are housed in the open cassette 18.

In the present embodiment, the open cassette 18 is not provided with a structure that maintains the positions of the wafers 22. Usually, a large force in the horizontal direction is not applied to the wafers 22 during transfer and hence, there is no possibility of the wafers 22 moving even when the opening part 24 is not configured to be closed. However, during traveling, there is a possibility of the wafers 22 moving due to centrifugal forces on curves or traveling vibrations. In view of the above, in the present embodiment, as will be described later, the holding device 10 is inclined during overhead traveling to effectively transport the wafers 22.

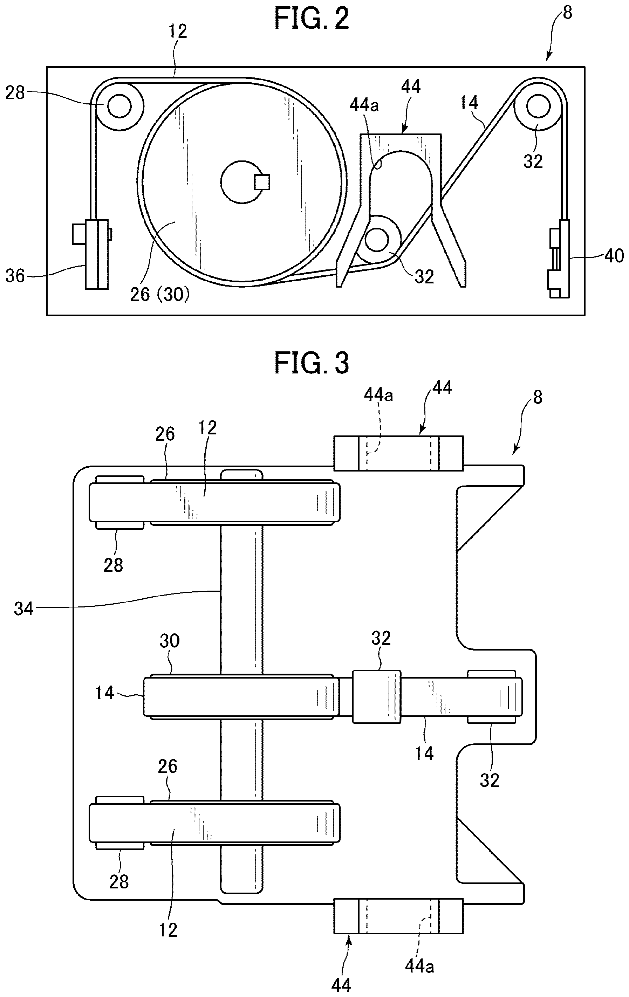

Next, a basic structure of the elevating/lowering device 8 will be described with reference to Figure 1 to Figure 3. Figure 2 is a left side view of the elevating/lowering device of the transport apparatus according to the embodiment of the present invention as viewed from the left side, showing a schematic configuration of the device. Figure 3 is a top plan view of the elevating/lowering device of the transport apparatus according to the embodiment of the present invention as viewed from the top, showing the schematic configuration of the device.

As shown in Figure 1 to Figure 3, the elevating/lowering device 8 includes first elevating/lowering belts (first suspension members) 12, being a pair of belts, a pair of elevating/lowering drums 26, and a pair of idler pulleys 28. The start ends of the first elevating/lowering belts 12 are attached to the elevating/lowering drums 26, and when the elevating/lowering drums 26 are rotationally driven, the first elevating/lowering belts 12 are wound up or wound down via the idler pulleys 28.

The elevating/lowering device 8 also includes the second elevating/lowering belt (second suspension member) 14, being a single belt, and an elevating/lowering drum 30 and two idler pulleys 32 for the second elevating/lowering belt. The start end of the second elevating/lowering belt 14 is attached to the elevating/lowering drum 30, and when the elevating/lowering drum 30 is rotationally driven, the second elevating/lowering belt 14 is wound up or wound down via the two idler pulleys 32.

Three elevating/lowering drums 26, 30 in total are driven by a common drive shaft 34 connected to a motor not shown in the drawing, so that all of the elevating/lowering drums 26, 30 are driven at the same rotational speed and by the same amount of rotation. Further, all of the three elevating/lowering drums 26, 30 have the same diameter. Accordingly, in the present embodiment, with such a configuration, when the elevating/lowering drums 26, 30 are rotated, the first elevating/lowering belts 12 and the second elevating/lowering belt 14 are wound up or wound down by the same length.

Next, as shown in Figure 1, the lower end of each first elevating/lowering belt 12 is attached to the holding device 10 via a first connecting member (first connecting bracket) 36 at a first position A on the opening part 24 side (front side), and the lower end of the second elevating/lowering belt 14 is attached to the holding device 10 via a second connecting member (second connecting bracket) 40 at a second position B on the rear side. That is, the first elevating/lowering belts 12 suspend the holding device 10 at the first positions A on the opening part 24 side of the open cassette 18 of the holding device 10, and the second elevating/lowering belt suspends the holding device 10 at the second position B on the rear side of the holding device 10.

In the present embodiment, a pair of positioning guide members (hereinafter referred to as "guide members") 44, which are open downward, are attached to the elevating/lowering device 8 of the vehicle body 2. As shown in Figure 3, this pair of guide members 44 are disposed at both left and right edge portions of the elevating/lowering device 8 and, as will be described later, a pair of positioning pin members (hereinafter referred to as "pin members") 46 provided to the holding device 10 abut against the pair of guide members 44. To be more specific, the pair of guide members 44 have recessed parts (abutted parts) 44a having a semicircular shape in cross section, and cylindrical parts (abutting parts) 46a of the pair of pin members 46 described later abut against these recessed parts 44a, the cylindrical parts 46a having a semicircular outer surface.

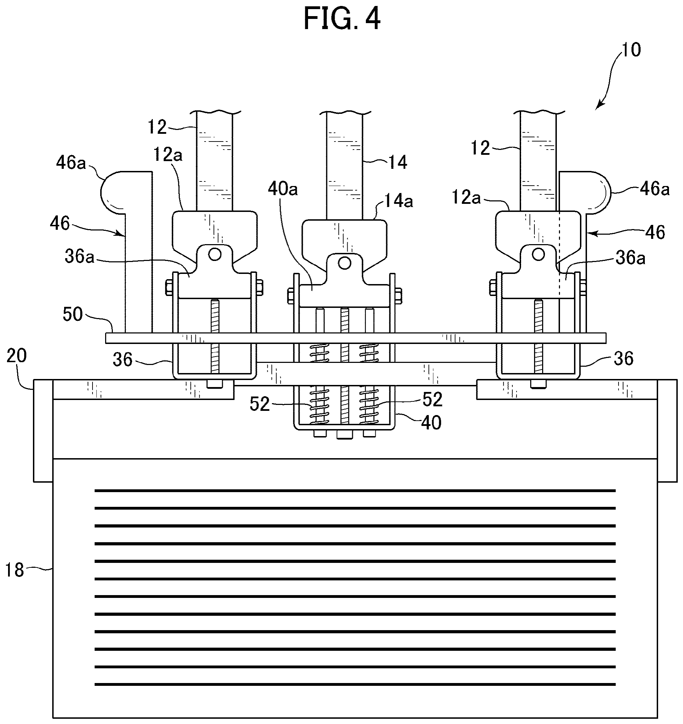

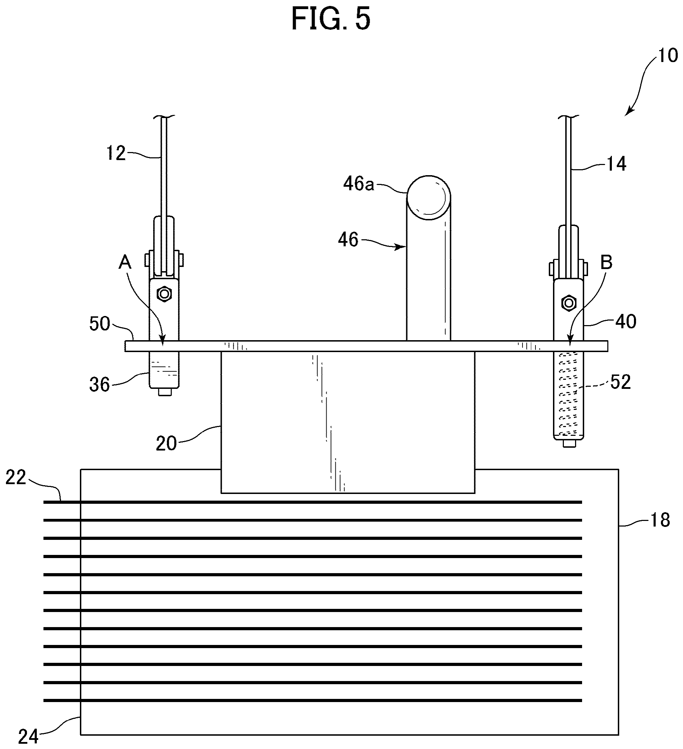

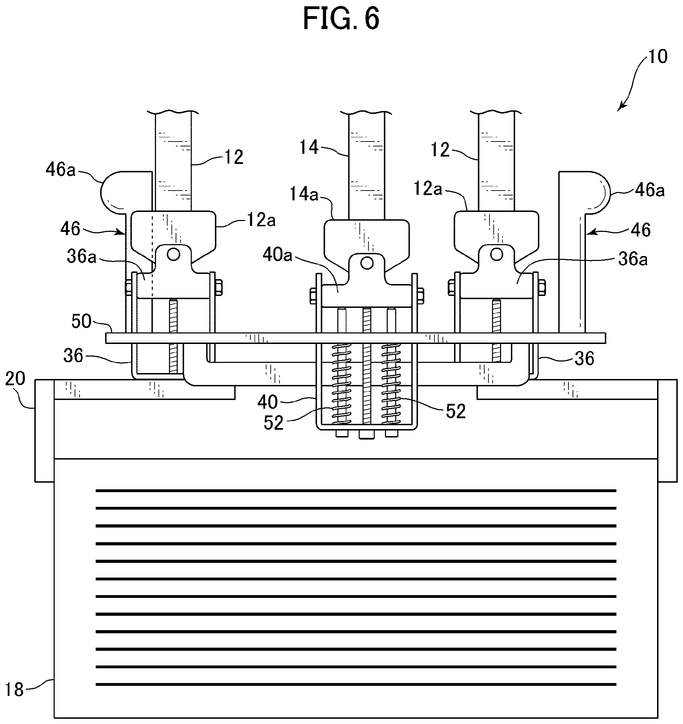

Next, a basic structure of the holding device 10 will be described with reference to Figure 4 to Figure 6. Figure 4 is a front view of the holding device according to the embodiment of the present invention, showing the schematic configuration of the device. Figure 5 is a left side view of the holding device according to the embodiment of the present invention, showing the schematic configuration of the device. Figure 6 is a back view of the holding device according to the embodiment of the present invention, showing the schematic configuration of the device.

First, as shown in Figure 4 to Figure 6, the holding device 10 includes a base plate 50 to which various parts are attached. In Figure 4 to Figure 6, the open cassette 18 is held by the chuck 20 provided to the holding device 10.

The pair of first elevating/lowering belts 12 are attached to the base plate 50 via the pair of first connecting members 36 at the first positions A (reference symbol "A" being given in side views in Figure 1 and Figure 5). The first connecting members 36 are U-shaped brackets or the like that are open upward.

Although there are a pair of first positions A, that is, two first positions A, to each of which the first elevating/lowering belt 12 is attached in a front view (Figure 4) and a back view (Figure 6), in a side view (Figure 1, Figure 5), the positions can be considered to be a single first position A. In the present embodiment, a description will be made on the assumption that the first position A refers to a single first position A in a side view.

Although the detailed description for an attaching structure will be omitted, at this first position A, the first connecting member 36 is fixed to the base plate 50, and the first connecting member 36 and the first elevating/lowering belt 12 are not displaced in the up-down direction relative to the base plate 50.

In addition, the second elevating/lowering belt 14 is attached to the base plate 50 via the second connecting member 40 at the second position B (reference symbol "B" being shown in side views in Figure 1 and Figure 5).

Although the detailed description for an attaching structure will be omitted, at this second position B, the second connecting member 40 is attached to the base plate 50 to be displaceable in the up-down direction relative to the base plate 50. Consequently, as will be described later, when the base plate 50 is inclined, the base plate 50 can be displaced relative to the second connecting member 40 and the second elevating/lowering belt 14.

In Figure 4 to Figure 6, reference symbol "12a" denotes the lower end portion of the first elevating/lowering belt 12, and is a part that is attached to the first connecting member 36. Reference symbol "36a" denotes a fixing member for attaching the lower end portion 12a to the first connecting member 36. Reference symbol "14a" denotes the lower end portion of the second elevating/lowering belt 14, and is a part that is attached to the second connecting member 40. Reference symbol "40a" denotes a fixing member for attaching the lower end portion 14a to the second connecting member 40.

Next, at the second position B, compression springs 52 are attached between the lower end portion of the second connecting member 40 (the bottom portion of the U-shaped bracket) and the lower surface portion of the base plate 50. In the present embodiment, the compression springs 52 mainly have two functions.

First, the compression springs 52 are assembled between the second connecting member 40 and the base plate 50 in a state of being compressed by a predetermined amount. With such a configuration, the compression springs 52 generate a predetermined amount of "pressurization" and, due to this pressurization, when the holding device 10 lifts the open cassette 18 on the load port 16, the compression springs 52 have a function of suppressing inclination of the holding device 10 and the open cassette 18, acting against the weight of the holding device 10 and the open cassette 18. To allow the compression spring 52 to generate a pressurization, the second connecting member 40 is configured to be restricted from being displaced to a position lower than a predetermined position.

Second, as will be described later with reference to Figure 7 to Figure 10, when the pin members 46 abut against the guide members 44 and, thereafter, the first elevating/lowering belts 12 and the second elevating/lowering belt 14 are further wound up, the second connecting member 40 is displaced relative to the base plate 50, and the compression springs 52 are compressed (contracted), thus having a function of allowing the base plate 50, as a result, the holding device 10, to be inclined. In other words, in the transport apparatus 1 of the present embodiment, the base plate 50, the second connecting member 40, which can be displaced in the up-down direction relative to the base plate 50, and the compression springs 52 mainly constitute an allowance part that allows the holding device 10 to be inclined.

Note that the compression springs 52 may be made of elastic materials, such as rubber, for example, that can exhibit a function described above.

Next, as shown in Figure 4 to Figure 6, the pair of pin members 46 extending upward are attached to both left and right edge portions of the holding device 10. Each of the pair of pin members 46 includes the cylindrical part (abutting part) 46a formed at the upper end portion thereof, the cylindrical part 46a having a semicircular outer surface having a size and a shape substantially the same as the size and the shape of the recessed part 44a of the guide member 44 described above.

As shown in Figure 5, the pair of pin members 46 are provided to be located between the first position A and the second position B as viewed in the horizontal direction in a side view, the holding device 10 being suspended by the first elevating/lowering belt 12 at the first position A, the holding device 10 being suspended by the second elevating/lowering belt 14 at the second position B. The pair of guide members 44 of the elevating/lowering device 8 described above are provided vertically above the pair of pin members 46 positioned as described above.

As a modification, members having a similar function to the pin members 46 may be provided to the vehicle body 2 (the elevating/lowering device 8, for example), and members having a similar function to the guide members 44 may be provided to the holding device 10. In such a modification, for example, based on a technical matter that the members abut against each other, the guide members 44 and the members having a similar function to the guide members 44 may be considered as "abutting members", and the pin members 46 and the members having a similar function to the pin members 46 may be considered as "abutted members". Also in such a modification, the abutting portions exhibit a function as "fulcrums" described later, thus allowing the holding device 10 to be inclined.

Further, as a modification, the pin members 46 may be disposed at a position that overlaps with the second position B in a side view as seen in Figure 5, for example. Furthermore, as a modification, the pin members 46 may be disposed outward of the second position B, thus the first position A, the second position B, and the pin member 46 may be arranged in this order as viewed in the horizontal direction in a side view. Also in these modifications, the abutting portions exhibit a function as "fulcrums" described later, thus allowing the holding device 10 to be inclined.

Although the pin members 46 are attached to the device 10, and the guide members 44 are attached to the device 8 in the present embodiment, as a modification, abutting parts and abutted parts having similar functions to the pin members 46 and the guide members 44 may be integrally formed with the vehicle body 2, the elevating/lowering device 8, or the holding device 10.

As a modification, a single pin member 46 and a single guide member 44 may be provided instead of the pair of pin members 46 and the pair of guide members 44. However, by using the pair of pin members 46 and the pair of guide members 44, it is possible to more effectively obtain the function as the "fulcrums" described later.

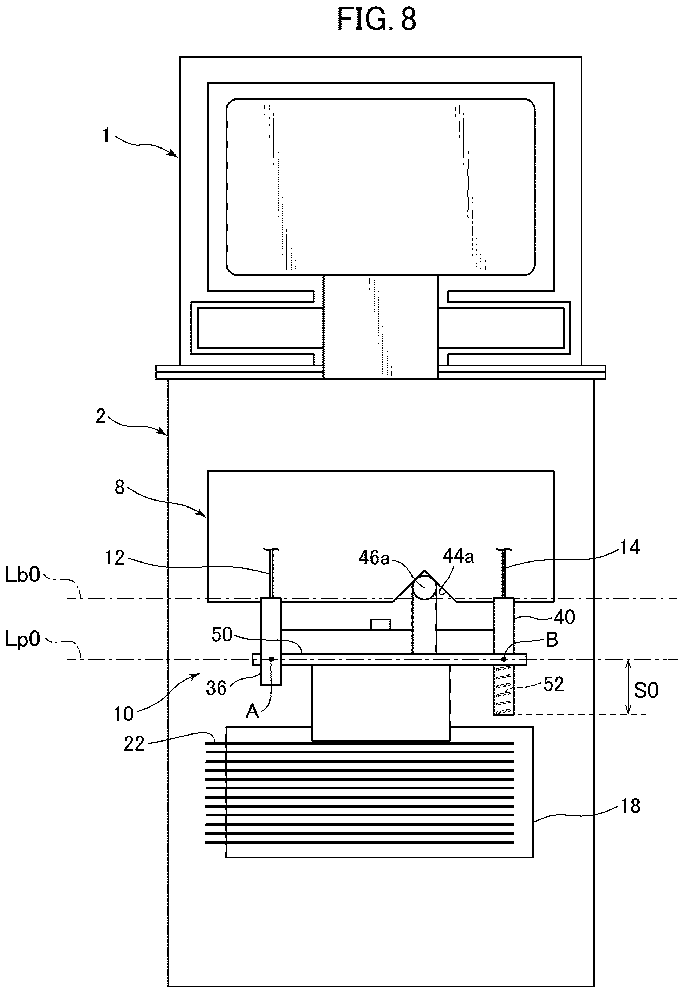

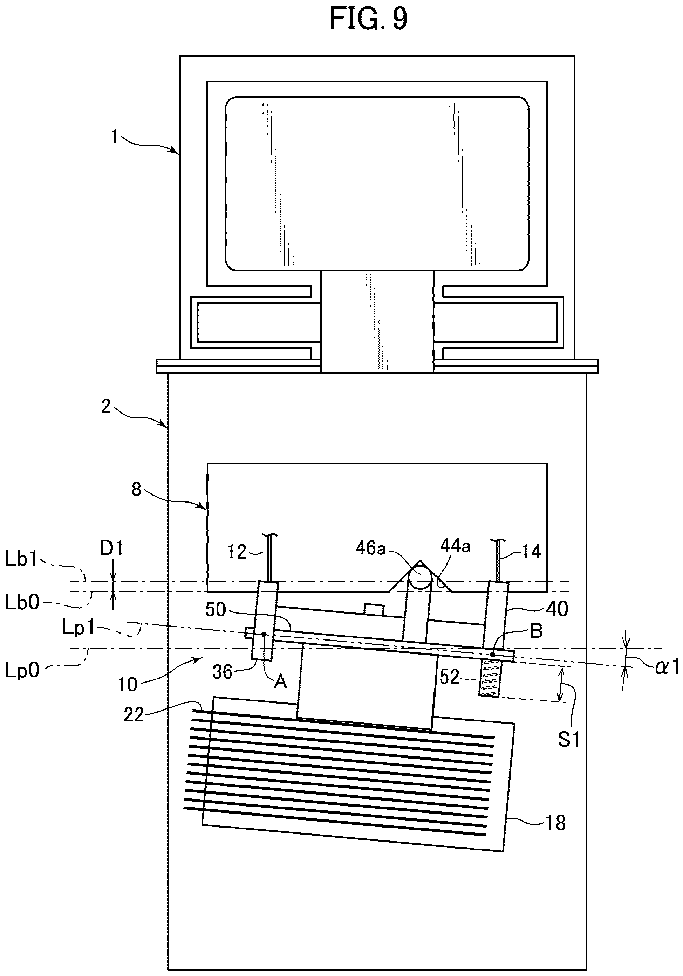

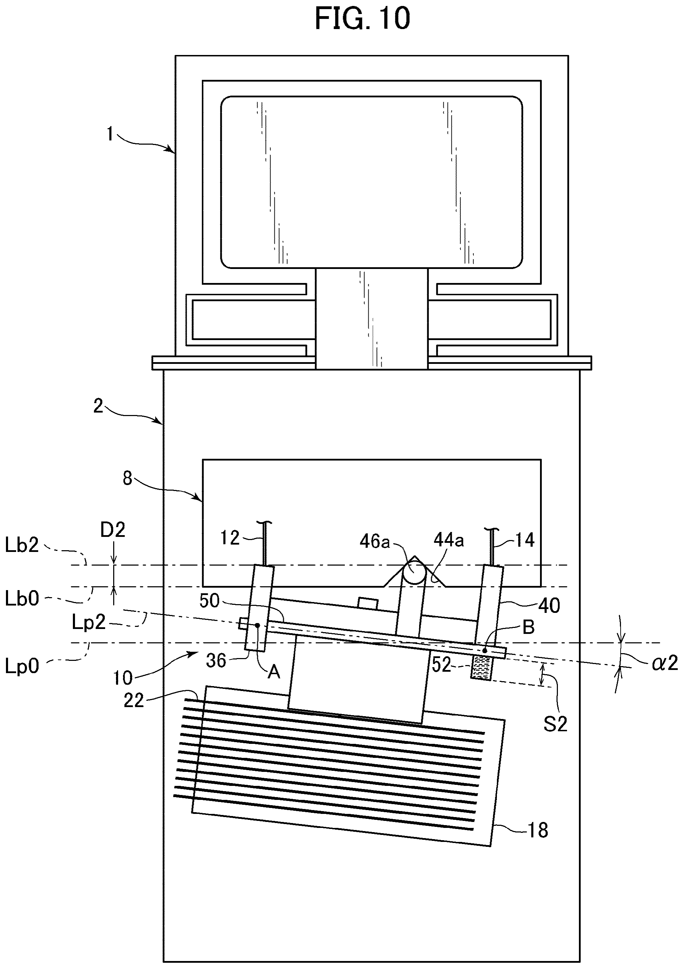

Next, the operation pattern of the transport apparatus 1 of the present embodiment will be described with reference to Figure 7 to Figure 10. Figure 7 is a schematic view showing the operation patterns of the transport apparatus of the present embodiment, wherein Figure 7(A) is a diagram for illustrating an operation at a transfer position at which the holding device has access to the transport articles on the load port, Figure 7(B) is a diagram for illustrating an operation in the course of elevation in which the holding device is lifted by the elevating/lowering belts, Figure 7(C) is a diagram for illustrating an operation when the holding device is lifted to a reference elevation position, Figure 7(D) is a diagram for illustrating an operation of the holding device in the course of further winding up the elevating/lowering belts, and Figure 7(E) is a diagram for illustrating an operation of the holding device when the winding-up of the elevating/lowering belts is completed. Figure 8 is a partially enlarged view of Figure 7(C) for illustrating the operation of the holding device at the reference elevation position in more detail. Figure 9 is a partially enlarged view of Figure 7(D) for illustrating an inclination operation of the holding device in more detail. Figure 10 is a partially enlarged view of Figure 7(E) for illustrating the inclination operation of the holding device in more detail.

In Figure 7 to Figure 10, the guide member 44 described above is illustrated in a simplified manner, and the recessed part (abutted part) 44a, which is open downward, is illustrated as a triangular recessed part.

First, as shown in Figure 7(A), on the load port 16, the wafers 22 are transferred, by hands or the like of a processing device not shown in the drawing, to the open cassette 18 that is held in a horizontal state by the holding device 10.

Next, as shown in Figure 7(B), the elevating/lowering drums 26, 30 are rotationally driven to wind up the first and second elevating/lowering belts 12, 14 by the same amount, thus elevating the holding device 10 holding the open cassette 18 in which the wafers 22 are stored. During this elevation, the holding device 10 maintains a horizontal posture due to the pressurization of the compression springs 52 described above.

Next, as shown in Figure 7(C), at a predetermined elevation position, the cylindrical parts 46a of the pin members 46 abut against the recessed parts 44a of the guide members 44. In the present embodiment, this predetermined elevation position is the highest position at which the holding device 10 maintains the horizontal posture (horizontal position), and hereinafter this position is referred to as "reference elevation position".

Next, after the holding device 10 reaches the reference elevation position shown in Figure 7(C), when the elevating/lowering drums 26, 30 are further rotationally driven to wind up the first and second elevating/lowering belts 12, 14 by the same amount, as shown in Figure 7(D), a state is brought about in which the holding device 10 is inclined by an angle α1 (for example, α1 = 3°).

As shown in Figure 7(E), the first and second elevating/lowering belts 12, 14 are further wound up by the same amount until the inclination of the holding device 10 reaches a final target angle α2 (for example, α2 = 6°), and winding up is finished at this position.

As described above, in the present embodiment, "elevation period (elevating/lowering period)" (the period shown in Figure 7(A) to Figure 7(C)) and "inclination period" (the period shown in Figure 7(C) to Figure 7(E)) are given, the first and second elevating/lowering belts 12, 14 being wound up to elevate the holding device 10 with the holding device 10 maintained in the horizontal posture in the "elevation period (elevating/lowering period)", the first and second elevating/lowering belts 12, 14 being wound up while preventing further elevation of the holding device 10 to change the holding device 10 from the horizontal posture to an inclined posture in the "inclination period".

Hereinafter, the operation of the holding device 10 when the "elevation period" shown in Figure 7(C) is finished, and the operations of the holding device 10 during the "inclination period" shown in Figure 7(D) and Figure 7(E) will be described in detail with reference to Figure 8 to Figure 10.

First, as shown in Figure 8, at the reference elevation position described above, the holding device 10 is elevated, and the cylindrical parts 46a of the pin members 46 abut against the recessed parts 44a of the guide members 44.

At this point of operation, the holding device 10 takes a horizontal posture as indicated by the posture of the base plate 50 shown by a chain line Lp0 (a line connecting the first position A and the second position B) in a side view (as viewed in the horizontal direction). That is, the horizontal position/the horizontal posture of the holding device 10 at the reference elevation position is defined by the abutment between the pin members 46 and the guide members 44. To be more specific, the highest elevation position at which such a horizontal posture of the holding device 10 is maintained is defined by the abutment between the pin members 46 and the guide members 44.

As described above, the winding-up amount of the first elevating/lowering belts 12 is equal to the winding-up amount of the second elevating/lowering belt 14 and hence, a chain line Lb0 that connects the lower ends of the elevating/lowering belts 12, 14 becomes horizontal.

In this state, a height SO of the compression spring 52 is equal to the height of the compression spring 52 when the compression spring 52 is initially assembled, or when the holding device 10 is in a horizontal posture.

Next, as shown in Figure 9, when the first and second elevating/lowering belts 12, 14 are further wound up (by the same winding-up amount) from the state in the reference elevation position shown in Figure 8, although a chain line Lb1 connecting the positions of the lower ends of the respective elevating/lowering belts 12, 14 remains horizontal, the chain line Lb1 is displaced upward relative to the chain line Lb0 (the positions of the lower ends of the belts at the "reference elevation position") by a distance D1 which corresponds to the winding-up amount.

A chain line Lp1, which is a line connecting the first position A and the second position B in this state, is inclined in a side view relative to the chain line Lp0 at the reference elevation position described above. Hereinafter, this mechanism will be described.

First, as described above, by winding up the first elevating/lowering belts 12, the first connecting members 36 fixed to the base plate 50 are elevated by an amount equal to such a winding-up amount.

At this point of operation, the pin members 46 abut against the recessed parts 44a of the guide members 44, and the pin members 46 are fixed to the base plate 50 and hence, as shown by the chain line Lp1, the base plate 50 (the holding device 10) takes an inclined posture in which the first position A is displaced upward by using the abutting portions between the cylindrical parts 46a of the pin members 46 and the recessed parts 44a of the guide members 44 as "fulcrums".

In contrast, the winding-up amount of the second elevating/lowering belt 14 is equal to the winding-up amount of the first elevating/lowering belts 12 and hence, the second connecting member 40 is elevated by the same amount as the first connecting members 36. In the present embodiment, the second connecting member 40 is attached to the base plate 50 to be displaceable in the up-down direction relative to the base plate 50, and the compression springs 52 are assembled between the base plate 50 and the second connecting member 40. Accordingly, with the elevation of the second connecting member 40, the compression springs 52 are compressed from the height SO shown in Figure 8 to a height S1 shown in Figure 9 and, consequently, the base plate 50 is allowed to be inclined (the chain line Lp1).

Due to such an inclination allowing effect of the compression springs 52, the holding device 10 takes an inclined posture in which the first position A is displaced upward, and the second position B is displaced downward.

As in the case of the modification described above, in the case in which the pin members 46 are disposed at the position that overlaps with the second position B in a side view, the fulcrum of the inclination of the base plate 50 matches the abutting portions at which the pin members 46 abut against the guide members 44 as viewed in the horizontal direction in a side view. Accordingly, in the case of such a modification, the holding device 10 takes an inclined posture in which the first position A is elevated, and the second position B remains in position.

Further, as in the case of the modification described above, in the case in which the first position A, the second position B, and the pin members 46 are arranged in this order in a side view, the fulcrum of the inclination of the base plate 50 is located outward of the second position B as viewed in the horizontal direction in a side view. Accordingly, in the case of such a modification, the holding device 10 takes an inclined posture in which the first position A is elevated, and the second position B is also elevated. In this case, the amount of elevation of the second position B is smaller than the amount of elevation of the first position A.

Next, as shown in Figure 10, the first and second elevating/lowering belts 12, 14 are further wound up by the same amount until the inclination angle reaches a target inclination angle α2.

At this point of operation, although a chain line Lb2 connecting the positions of the lower ends of the respective elevating/lowering belts 12, 14 remains horizontal, the chain line Lb2 is displaced upward relative to the "reference elevation position" shown by the chain line Lb0 by a distance D2, which corresponds to the total winding-up amount from the reference elevation position.

Due to the mechanism described with reference to Figure 9, the posture of the holding device 10 indicated by a chain line Lp2, which is a line connecting the first position A and the second position B in this state, becomes inclined relative to the horizontal posture of the chain line Lp0 at the reference elevation position in a side view.

In this state, the compression springs 52 are further compressed to a height S2 (smaller than S1) and, consequently, the holding device 10 is allowed to be inclined.

When wafers 22 are unloaded, by merely winding down the respective elevating/lowering belts 12, 14 by the same amount, the holding device 10 and the wafers 22 (the open cassette 18), being the transport articles, take a horizontal state. Consequently, the transport articles can be inclined only during vehicle traveling with a simple structure and by a control method substantially similar to the method for the normal control of the elevating/lowering drums 26, 30.

Next, the manner of operation and advantageous effects of the transport apparatus of the overhead traveling type according to the embodiment of the present invention will be described.

First, the transport apparatus 1 of the overhead traveling type according to the present embodiment and the modification is the transport apparatus 1 of the overhead traveling type that travels along an overhead track 4 to transport the articles 22, the transport apparatus 1 including: the vehicle body 2; the holding device 10 configured to hold the articles; and the elevating/lowering device 8 configured to elevate/lower the holding device 10 relative to the vehicle body 2, wherein the elevating/lowering device 8 includes the first belt members (first suspension members) 12, the second belt member (second suspension member) 14, and the driving devices 26, 30, 34, the first belt members (first suspension members) 12 and the second belt member (second suspension member) 14 being configured to suspend the holding device 10, driving devices 26, 30, 34 being configured to wind up and wind down the first belt members and the second belt member, the holding device 10 includes the abutting members (46) configured to abut against the vehicle body 2 at the predetermined elevation position (reference elevation position) up to which the holding device 10 is elevated relative to the vehicle body 2, the vehicle body 2 includes the abutted members (44) against which the abutting members 46 of the holding device 10 abut, the first belt member 12 is configured to suspend the holding device 10 at the first position A on the holding device, and the second belt member 14 is configured to suspend the holding device 10 at the second position B on the holding device, the driving devices 26, 30 are configured to wind up or wind down the first belt members 12 and the second belt member 14 by the same length, and the transport apparatus 1 further includes the allowance parts (spring, rubber, or the like) 52 configured to, when the first belt members 12 and the second belt member 14 are wound up by the same length at the predetermined elevation position (reference elevation position) at which the abutting members of the holding device 10 abut against the abutted members of the vehicle body 2, allow the holding device 10 to be inclined (α1, α2) by using the abutting portions (46a, 44a) between the abutting members and the abutted members as the fulcrums.

According to the present embodiment having such a configuration, the holding device 10 can be inclined by a certain desired inclination angle (α2), irrespective of an elevating/lowering distance (the winding-up amount of the belt members/the suspension members).

In the present embodiment, the abutting members 46 of the holding device 10 are provided between the first position A and the second position B as viewed in the horizontal direction, and when the first belt members 12 and the second belt member 14 are wound up by the same length at the predetermined elevation position (reference elevation position), the allowance parts (52) allow the holding device 10 to be inclined (α1, α2) such that the first position A is displaced upward, and the second position B is displaced downward by using the abutting portions (46a, 44a) between the abutting members and the abutted members as the fulcrums and hence, the holding device 10 can be more effectively inclined by the certain desired inclination angle (α2).

In the present embodiment, the allowance part includes the elastic members (springs 52, rubber) configured to, when the first belt members 12 and the second belt member 14 are wound up by the same length at the predetermined elevation position (reference elevation position), be elastically deformed to allow the holding device 10 to be inclined by using the abutting portions (46a, 44a) between the abutting members (46) and the abutted members (44) as the fulcrums and hence, it is possible to more effectively allow the holding device 10 to be inclined.

In the present embodiment, the elastic members 52 are contracted with respect to the natural length of the elastic members 52 in a state in which the holding device 10 holds no articles 10, 22 and hence, a pressurization that is generated by an amount corresponding to the contraction of the elastic members 52 from the natural length is applied to the holding device 10. Accordingly, when the holding device 10 holding the articles is lifted (from the load port 16, for example), it is possible to suppress inclination of the holding device 10.

In the present embodiment, the abutting members (46) of the holding device 10 and the abutted members (44) of the vehicle body 2 define the horizontal position (Lp0) and the elevation position (Lb0) of the holding device 10 at the predetermined elevation position (reference elevation position) and hence, in addition to the role as the "fulcrum" when the holding device 10 is inclined, the abutting members and the abutted members also play a role in positioning when the holding device 10 is elevated.

In the present embodiment, the first connecting members 36 are provided at the first positions A of the holding device 10, the first connecting members 36 connecting the first belt members 12 to the base plate (base member) 50 of the holding device 10, the second connecting member 40 is provided at the second position B of the holding device 10, the second connecting member 40 connecting the second belt member 14 to the base plate 50 of the holding device 10, the first connecting members 36 are fixed to the base plate 50, the second connecting member 40 is attached to the base plate 50 to be displaceable in the up-down direction relative to the base plate 50, and the allowance part includes the elastic members (spring, rubber, or the like) 52 that are provided between the base plate 50 and the second connecting member 40 to allow a relative displacement between the base plate 50 and the second connecting member 40.

According to the present embodiment having such a configuration, the elastic members 52 are deflected by receiving a force from the base plate 50 of the holding device 10 and the second connecting member 40 connected to the second belt member 14 and hence, it is possible to effectively allow the holding device 10 to be inclined.

In the present embodiment, the elevating/lowering device 8 is attached to the vehicle body 2, and the abutted members 44 of the vehicle body 2 are attached to the elevating/lowering device 8 attached to the vehicle body 2. The abutting members 46 are the pin members 46 that protrude upward, and the abutted members 44 are the guide members 44 that are open downward, and that are configured to receive and support the pin members 46 and hence, the holding device 10 can be more effectively inclined by the certain desired inclination angle (α2).

### Reference Signs List

A first position
B second position
D1, D2 winding-up amount of elevating/lowering belt from reference elevation position/amount of elevation of holding device
Lb0, Lb1, Lb2 line connecting positions of lower ends of first and second elevating/lowering belts
Lp0, Lp1, Lp2 line connecting first position A and second position B/inclined posture of holding device
1 transport apparatus of overhead traveling type
2 vehicle body
4 track rail
6 traveling mechanism
8 elevating/lowering device
10 holding device
12 first elevating/lowering belt (first suspension member)
14 second elevating/lowering belt (second suspension member)
16 load port
18 open cassette
22 wafer (article, transport article)
26, 30 elevating/lowering drum
34 drive shaft
36 first connecting member/first connecting bracket
40 second connecting member/second connecting bracket
44 guide member (abutted member)
44a recessed part (abutted part)
46 pin member (abutting member)
46a cylindrical part (abutting part)
50 base plate (base member)
52 compression spring (allowance part, pressurization member)

## Claims

1. A transport apparatus of an overhead traveling type, the transport apparatus traveling along an overhead track to transport an article, the transport apparatus comprising:
a vehicle body; a holding device configured to hold the article; and an elevating/lowering device configured to elevate/lower the holding device relative to the vehicle body, wherein
the elevating/lowering device includes a first suspension member, a second suspension member, and a driving device, the first suspension member and the second suspension member being configured to suspend the holding device, the driving device being configured to wind up and wind down the first suspension member and the second suspension member,
the holding device includes an abutting member configured to abut against the vehicle body at a predetermined elevation position up to which the holding device is elevated relative to the vehicle body,
the vehicle body includes an abutted member against which the abutting member of the holding device abuts,
the first suspension member is configured to suspend the holding device at a first position on the holding device, and the second suspension member is configured to suspend the holding device at a second position on the holding device,
the driving device is configured to wind up or wind down the first suspension member and the second suspension member by a same length, and
the transport apparatus further comprises an allowance part configured to, when the first suspension member and the second suspension member are wound up by the same length at the predetermined elevation position at which the abutting member of the holding device abuts against the abutted member of the vehicle body, allow the holding device to be inclined by using an abutting portion between the abutting member and the abutted member as a fulcrum.

2. The transport apparatus according to claim 1, wherein
the abutting member of the holding device is provided between the first position and the second position as viewed in a horizontal direction, and
when the first suspension member and the second suspension member are wound up by the same length at the predetermined elevation position, the allowance part allows the holding device to be inclined such that the first position is displaced upward, and the second position is displaced downward by using the abutting portion between the abutting member and the abutted member as the fulcrum.

3. The transport apparatus according to claim 1 or claim 2, wherein the allowance part includes an elastic member configured to, when the first suspension member and the second suspension member are wound up by the same length at the predetermined elevation position, be elastically deformed to allow the holding device to be inclined by using the abutting portion between the abutting member and the abutted member as the fulcrum.

4. The transport apparatus according to claim 3, wherein the elastic member is contracted with respect to a natural length of the elastic member in a state in which the holding device holds no article.

5. The transport apparatus according to claim 1 or claim 2, wherein the abutting member of the holding device and the abutted member of the vehicle body define a horizontal position and an elevation position of the holding device at the predetermined elevation position.

6. The transport apparatus according to claim 1 or claim 2, wherein
a first connecting member is provided at the first position of the holding device, the first connecting member connecting the first suspension member to a base member of the holding device,
a second connecting member is provided at the second position of the holding device, the second connecting member connecting the second suspension member to the base member of the holding device,
the first connecting member is fixed to the base member,
the second connecting member is attached to the base member to be displaceable in an up-down direction relative to the base member, and
the allowance part includes an elastic member that is provided between the base member and the second connecting member to allow a relative displacement between the base member and the second connecting member.

7. The transport apparatus according to claim 1 or claim 2, wherein
the abutting member is a pin member that protrudes upward, and
the abutted member is a guide member that is open downward, and that is configured to receive and support the pin member.
